# EUROPÄISCHE PATENTSCHRIFT

(11) **EP 2 929 764 B1**
(45) Veröffentlichungstag und Bekanntmachung des Hinweises auf die Patenterteilung: **27.01.2021**
(21) Anmeldenummer: 13811124.0
(22) Anmeldetag: 04.12.2013
(51) Int. Cl.: H05K 5/02, E05D 7/10, H02B 1/38, H02B 1/44

(54) **KASTEN MIT GELENKEINRICHTUNG**
BOX COMPRISING A HINGE DEVICE
BOÎTE MUNIE D'UNE ARTICULATION

(30) Priorität: 06.12.2012 DE 102012023991
(43) Veröffentlichungstag der Anmeldung: 14.10.2015
(73) Patentinhaber: Eaton Protection Systems IP GmbH & Co. KG, 12529 Schönefeld (DE)
(72) Erfinder: KETTERER, Michael, 59494 Soest (DE)
(74) Vertreter: BRP Renaud & Partner mbB Rechtsanwälte Patentanwälte Steuerberater
(86) Internationale Anmeldenummer: PCT/EP2013/003665
(87) Internationale Veröffentlichungsnummer: WO 2014/086488

(56) Entgegenhaltungen:
- CH-A- 417 727
- DE-A1- 3 543 989
- DE-A1-102006 052 723
- DE-C1- 19 623 084
- FR-A3- 2 814 321

## Beschreibung

Die Erfindung betrifft einen Kasten, insbesondere zum Einsatz im Ex-Bereich. Ein solcher Kasten dient beispielsweise zur Aufnahme von Klemmen, Schaltern, Steckvorrichtungen, oder dergleichen, die im Ex-Bereich verwendet werden. In dem Kasten können außerdem weitere elektrische und elektronische Einrichtungen angeordnet sein. Falls ein solches Deckelteil vollständig vom Kastenunterteil lösbar ist, besteht die Gefahr, dass ein falsches Deckelteil auf ein Kastenunterteil aufgesetzt wird, oder gegebenenfalls das Deckelteil verloren geht.

DE 35 43 989 A1 beschreibt einen Kasten mit dem Merkmal des Oberbegriffs des Patentanspruchs 1. Allerdings fehlt bei diesem eine besondere Verschwenkbarkeit eines entsprechenden Gelenkteils, insbesondere im Kastenunterteil.

CH 417 727 A beschreibt einen Rahmen, der an einer Wand oder dergleichen befestigt ist. Dieser kann durch eine Vorderplatte verschlossen werden. Zwischen Vorderplatte und Rahmen ist eine Gelenkeinrichtung angeordnet, wobei ein Teil der Gelenkeinrichtung beweglich ist. Dieser Teil ist der Vorderplatte zugeordnet.

DE 10 2006 052 723 A1 beschreibt ein Gehäuse mit einem Deckel und einer Gelenkeinrichtung, wobei keine besondere Verschwenkbarkeit der Gelenkeinrichtung im jeweiligen Teil beschrieben wird.

Aufgabe vorliegender Erfindung ist, einen Kasten der eingangs genannten Art dahingehend zu verbessern, dass in einfacher Weise eine permanente Verbindung zwischen Deckelteil und Kastenunterteil bei gleichzeitiger Verschwenkbarkeit dieser Teile zueinander in sicherer Weise und kostengünstig möglich ist.

Diese Aufgabe wird durch die Merkmale des Patentanspruchs 1 gelöst.

Insbesondere ist ein Gelenkteil gleitverschieblich gelagert und das andere Gelenkteil zumindest verschraubbar im jeweils zugeordneten Kastenunterteil beziehungsweise Deckelteil angeordnet. Durch die verschwenkbare Lagerung der beiden Gelenkteile miteinander, sind diese in der Regel nicht trennbar. Gleichzeitig ist ein Gelenkteil gleitverschieblich zum vereinfachten Öffnung und Schließen des Deckelteils in einem Teil des Kastens gelagert, während das andere Gelenkteil mit dem jeweils anderen Teil des Kastens verschraubt ist. Durch die Gleitverschieblichkeit ergibt sich ein gewisses Anheben und Absenken des Deckelteils je nach Verschwenken in Öffnung- oder Schließstellung. Gleichzeitig soll das entsprechende gleitverschiebliche Gelenkteil ebenfalls im entsprechenden Teil des Kastens so angeordnet sein, dass es nicht ohne weiteres von diesem lösbar ist.

Eine entsprechende Gleitverschieblichkeit ergibt sich in einfacher Weise beispielsweise dadurch, wenn das untere Gelenkteil gegebenenfalls als Verschiebebolzen mit einem an einem Flanschende zumindest teilweise umlaufenden Randflansch ausgebildet ist, wobei an einem dem Flanschende gegenüberliegenden Lagerende das obere Gelenkende verschwenkbar gelagert ist. Durch den Randflansch wird verhindert, dass das untere Gelenkteil aus beispielsweise dem Kastenunterteil herausziehbar ist beziehungsweise von diesem lösbar ist. Erst nach Ausschrauben des in diesem Fall zum Verschrauben ausgebildeten oberen Gelenkteils kann das untere Gelenkteil vom Kastenunterteil gelöst werden. Um eine gute Verschiebbarkeit und gegebenenfalls auch Drehbarkeit zu ermöglichen, kann der Verschiebebolzen einen im Wesentlichen kreisförmigen Querschnitt und eine glatte Außenseite aufweisen.

Um bei einem Ausführungsbeispiel eine Verdrehbarkeit der Gelenkeinrichtung zu verhindern, kann der Randflansch einen ovalen, eckigen oder anderen nicht-kreisförmigen Querschnitt aufweisen, der im Wesentlichen einem Querschnitt einer Randflanschvertiefung im Kastenunterteil entspricht. D. h., dass bei Deckelteil in Schließstellung der Randflansch mit seinem entsprechenden Querschnitt in dem geometrisch ähnlichen Querschnitt der Randflanschvertiefung angeordnet und dort insbesondere drehfest gehalten ist.

Bei einem einfachen Ausführungsbeispiel kann die Randflanschvertiefung direkt an einem Ende einer Schiebebolzenbohrung in einem Randbereich des Kastenunterteils ausgebildet sein.

Um das Deckelteil ausreichend weit öffnen und gegebenenfalls in der Öffnungsstellung ohne Festhalten anordnen zu können, kann ein Schwenkbereich von oberem Gelenkteil zum unteren Gelenkteil größer als 90°, vorzugsweise 180° und insbesondere bevorzugt bis zu 220° sein.

Ein einfaches Verschrauben des oberen Gelenkteils kann sich dadurch ergeben, wenn das obere Gelenkteil einen Einschraubbolzen zumindest an seinem zu dem mit dem unteren Gelenkteil verschwenkbar verbundenen Schwenkendabschnitt gegenüberliegenden Einschraubendabschnitt aufweist.

Eine einfache Verschwenkbarkeit zwischen unterem und oberem Gelenkteil kann sich dadurch ergeben, wenn das Lagerende des unteren Gelenkteils zwei voneinander durch einen Lagerspalt beabstandete Lagervorsprünge aufweist, zwischen denen eine Lagerwelle für das Verschwenken des oberen Gelenkteils angeordnet ist. Insbesondere ist das obere Gelenkteil an dieser Lagerwelle mit seinem Schwenkendabschnitt gelagert.

Um eine ausreichend stabile Gelenkeinrichtung zu erhalten, die dennoch beispielsweise durch die entsprechende Schiebebolzenbohrung entnehmbar ist, kann ein Durchmesser des oberen Gelenkteils kleiner und höchstens gleich einem Durchmesser des unteren Gelenkteils sein.

Um auch das obere Gelenkteil gegebenenfalls in die Schiebebolzenbohrung einschieben zu können, kann das obere Gelenkteil einen mittleren im Wesentlichen zylindrischen Mittelabschnitt aufweisen, von dem der Einschraubendabschnitt als mit Außengewinde ausgebildeter Einschraubbolzen und der Schwenkendabschnitt abstehen.

Bei einem weiteren Ausführungsbeispiel besteht außerdem die Möglichkeit, dass im Wesentlichen das gesamte obere Gelenkteil als Einschraubbolzen ausgebildet ist, der einseitig den entsprechenden Schwenkendabschnitt aufweist.

Um beim Einschrauben des oberen Gelenkteils eine bestimmte Einschraubstellung der Gelenkeinrichtung festzulegen, kann beispielsweise zwischen Mittelabschnitt und Einschraubbolzen ein Einschraubanschlag ausgebildet sein. D. h., das obere Gelenkteil wird soweit in das Deckelteil eingeschraubt, bis der Einschraubanschlag an diesem oder in einer entsprechenden Vertiefung des Deckelteils anliegt.

Eine einfache Anordnung der Gelenkeinrichtung kann darin gesehen werden, wenn diese beispielsweise an im Wesentlichen zwei Kastenecken anordbar ist. D. h., in diesen entsprechenden Kastenecken sind zwei Schiebebolzenbohrungen ausgebildet, in denen jeweils ein unteres Gelenkteil verschieblich angeordnet ist. Das obere Gelenkteil steht in Richtung Deckelteil vor und ist mit diesem über den Einschraubbolzen verschraubt.

Die Erfindung betrifft ebenfalls eine entsprechende Gelenkeinrichtung wie sie im Vorangehenden beschrieben wurde, d. h. mit unterem und oberem Gelenkteil, welche verschwenkbar miteinander verbunden sind, wobei ein Gelenkteil gleitverschieblich und das andere Gelenkteil zumindest teilweise verschraubbar ausgebildet ist. Die übrigen Merkmale der Gelenkeinrichtung ergeben sich durch die vorangehende Beschreibung.

Im Folgenden werden vorteilhafte Ausführungsbeispiele der Erfindung anhand der in der Zeichnung beigefügten Figuren erläutert.

Es zeigen:
- Figur 1: eine teilweise Ansicht eines erfindungsgemäßen Kastens mit Gelenkeinrichtung;
- Figur 2: die Gelenkeinrichtung nach Figur 1 in Alleindarstellung;
- Figur 3: einen Längsschnitt durch die Gelenkeinrichtung nach Figur 1, und
- Figur 4: eine Darstellung analog zu Figur 2 für ein weiteres Ausführungsbeispiel einer Gelenkeinrichtung.

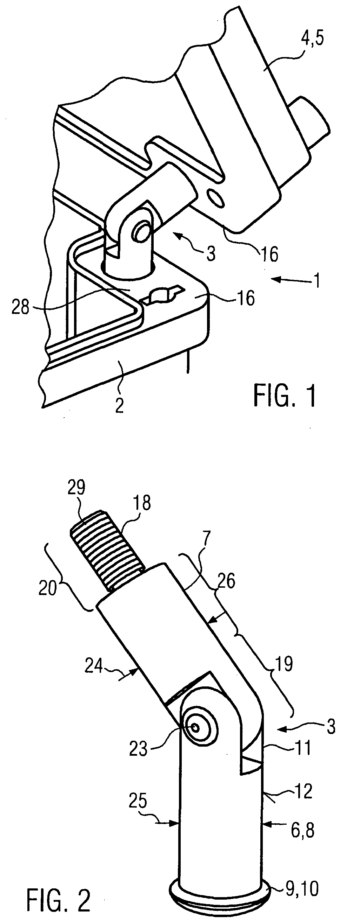

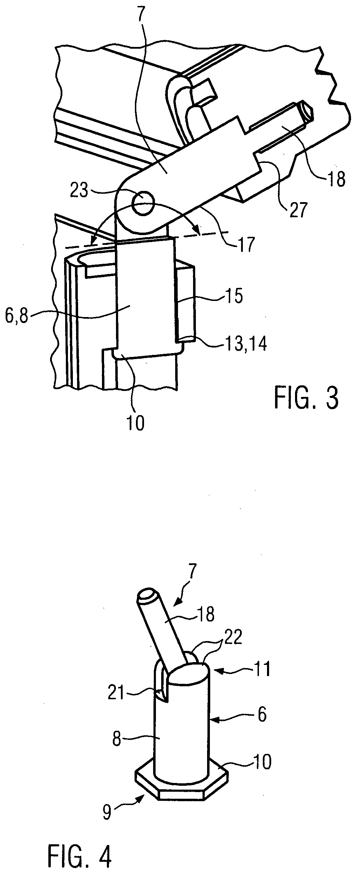

Figur 1 zeigt eine teilweise Darstellung eines Eckbereichs eines erfindungsgemäßen Kastens 1 mit zwischen Kastenunterteil 2 und Deckelteil 4 angeordneter Gelenkeinrichtung 3. Das Deckelteil 4 ist in einer teilweisen Öffnungsstellung 5 dargestellt, wobei ein entsprechender Schwenkbereich 17, siehe auch Figur 3, im Wesentlichen 180° zwischen Öffnungsstellung und Schließstellung beträgt.

Das Kastenunterteil 2 weist einen Innenraum auf, in dem elektrische oder elektronische Einrichtungen angeordnet sein können. Diese sind in den Figuren nicht dargestellt.

Die Gelenkeinrichtung 3 umfasst ein unteres Gelenkteil 6, siehe auch Figur 2, und ein oberes Gelenkteil 7. Diese sind an einander zugeordneten Enden verschwenkbar miteinander verbunden. In Figur 2 ist die Gelenkeinrichtung 3 ohne Kasten 1 dargestellt.

Das obere Gelenkteil 7 weist einen im Wesentlichen zylindrischen Mittelabschnitt 26 auf. Dieser hat einen Durchmesser 24, der im Wesentlichen einem Durchmesser 25 des unteren Gelenkteils 6 entspricht oder kleiner ist. Der Mittelabschnitt 26 weist an einem dem Deckelteil 4 zuweisenden Ende, siehe auch Figur 1, einen Einschraubendabschnitt 20 auf, der durch einen mit Außengewinde 29 ausgebildeten Einschraubbolzen 18 gebildet ist. Zwischen Einschraubbolzen 18 und dem Mittelabschnitt 26 ist ein Einschraubanschlag 27 ausgebildet, siehe auch Figur 3.

Der Mittelabschnitt 26 weist an seinem anderen, dem Einschraubendabschnitt 20 gegenüberliegenden Ende einen Schwenkendabschnitt 19 auf. Dieser ist im Wesentlichen durch eine Lagerlasche mit mittlerer Lagerbohrung gebildet. Durch diese mittlere Lagerbohrung ist eine Lagerwelle 23 hindurchgeführt. Der Schwenkendabschnitt 19 ist in einem Lagerspalt 21 angeordnet, der zwischen zwei beabstandeten Lagervorsprüngen 22 an einem Lagerende 11 des unteren Gelenkteils 6 gebildet ist. Die Lagerwelle 23 erstreckt sich zwischen diesen beiden Lagervorsprüngen 22.

Das untere Gelenkteil 6 weist anschließend an das Lagerende 11 einen Verschiebebolzen 8 mit im Wesentlichen glatter Außenseite 12 auf. Der Querschnitt des Verschiebebolzen 8 ist kreisförmig. An seinem dem Lagerende gegenüberliegenden Flanschende 9 weist das untere Gelenkteil 6 einen radial nach außen vorstehenden Randflansch 10 auf. Dieser ist vollständig umlaufend, wobei auch teilweise umlaufende Randflansche 10 möglich sind.

Nach Figur 3 ist der Verschiebebolzen 8 in einer entsprechenden Verschiebebolzenbohrung 15 im Kastenunterteil 2 verschieblich gelagert. Die Verschiebebolzenbohrung 15 befindet sich in einem Randbereich 16 des Kastenunterteils nahe einer Ecke, siehe auch Figur 1. Dies gilt analog für eine Einschraubbohrung im Deckelteil 4, siehe Figuren 1 und 3 und den in diese Einschraubbohrung eingeschraubten Einschraubbolzen 18. Die Einschraubtiefe des Einschraubbolzens 18 ist durch eine Anlage des Einschraubanschlags 27 an einem Ende der entsprechenden Einschraubbohrung im Deckelteil 4 bestimmt, siehe Figur 3.

Das untere Gelenkteil 6 ist in der Verschiebebolzenbohrung 15 verschieblich gelagert, wobei die Stellung nach Figur 3 durch Anlage des Randflansches 10 an einem Ende der Verschiebebolzenbohrung 15 festgelegt ist.

Bei Schließen des Deckelteils 4 wird das Deckelteil auf dem Kastenunterteil 2 abgelegt, wobei in dieser Schließstellung der Verschiebebolzen 8 in der Verschiebebolzenbohrung 15 in Figur 3 nach unten verschoben wird, sodass zumindest teilweise das obere Gelenkteil 7 in der Verschiebebolzenbohrung 15 angeordnet ist. In dieser Schließstellung von Deckelteil 4 und Kastenunterteil 2 ist dann das Deckelteil 4 am Kastenunterteil 2 festschraubbar.

In der Öffnungsstellung nach Figuren 1 beziehungsweise 3, ist der Verschiebebolzen 8 so weit nach oben in diesen Figuren innerhalb der Verschiebebolzenbohrung 15 verschoben, dass der Randflansch 10 von unten am Ende der Verschiebebolzenbohrung 15 anliegt.

Dadurch ist sichergestellt, dass auch bei Deckelteil in Öffnungsstellung das Deckelteil noch mit dem Kastenunterteil verbunden ist und beispielsweise nicht verloren gehen kann oder gegen ein falsches Deckelteil ausgetauscht werden kann.

Es ergibt sich somit eine permanente und feste Verbindung zwischen Deckelteil und Kastenunterteil, die beispielsweise nur durch Ausschrauben des Einschraubbolzens 18 aus der entsprechenden Einschraubbohrung im Deckelteil lösbar ist.

In Figur 4 ist ein zweites Ausführungsbeispiel der Gelenkeinrichtung 3 dargestellt. Diese unterscheidet sich von der vorangehend beschriebenen insbesondere dadurch, dass das obere Gelenkteil 7 im Wesentlichen vollständig durch einen Einschraubbolzen 18 gebildet ist. Dieser erstreckt sich bis zum Schwenkendabschnitt 19, der analog zu Figur 2 in einem Lagerspalt 21 zwischen Lagervorsprüngen 22 aufgenommen und dort verschwenkbar gelagert ist.

Ein weiterer Unterschied zu dem bisher beschriebenen Ausführungsbeispiel ergibt sich dadurch, dass der Randflansch 10 einen anderen Querschnitt aufweist. Während der Randflansch 10 nach Figur 2 einen kreisförmigen Querschnitt aufweist, hat der Randflansch 10 nach Figur 4 einen Mehreckquerschnitt. In diesem Zusammenhang ist insbesondere zu beachten, dass bei einer Anordnung der Gelenkeinrichtung 3 nach Figur 4 analog zu Figur 3 dieser mehreckige Randflansch 10 in einer entsprechend geformten Randflanschvertiefung 13 am unteren Enden der Verschiebebolzen 15 aufgenommen ist. Die Randflanschvertiefung 13 weist einen Querschnitt passend zum Randflansch 10 auf, sodass dieser in einer Anordnung analog zu Figur 3 drehfest in der Randflanschvertiefung 13 angeordnet ist.

Erfindungsgemäß ergibt sich ein Kasten mit Gelenkeinrichtung oder auch eine Gelenkeinrichtung an sich, die zur Verbindung von Kastenunterteil und Deckelteil dient und durch die ein Lösen des Deckelteils beim Öffnen vermieden wird. Stattdessen wird durch das Gelenkteil eine permanente Verbindung zwischen Deckelteil und Kastenunterteil geschaffen. Durch die entsprechende Verschiebbarkeit des unteren Gelenkteils im Kastenunterteil ergibt sich allerdings eine einfache Öffnung des Deckelteils mit großem Öffnungswinkel durch den entsprechenden Schwenkbereich zwischen unterem Gelenkteil und oberem Gelenkteil und insbesondere durch die Verschiebbarkeit des unteren Gelenkteils im Kastenunterteil.

Die gesamte Gelenkeinrichtung ist außerhalb des Öffnungsbereichs des Kastenunterteils angeordnet, sodass entsprechende Öffnungen zum Inneren des Kastenunterteils vermieden werden.

## Patentansprüche

1. Kasten (1), insbesondere zum Einsatz im Ex-Bereich, mit einem Kastenunterteil (2) und einem relativ zu diesem mittels einer Gelenkeinrichtung (3) verschwenkbar zwischen einer Öffnung- und einer Schließstellung gelagerten Deckelteil (4), wobei die Gelenkeinrichtung (3) ein unteres, dem Kastenunterteil (2) zugeordnetes und ein oberes, dem Deckelteil zugeordnetes Gelenkteil (6, 7) aufweist, welche verschwenkbar miteinander verbunden sind, wobei ein Gelenkteil (6, 7) gleitverschieblich gelagert und das andere Gelenkteil (7, 6) zumindest teilweise verschraubbar im jeweils zugeordneten Kastenunterteil (2) beziehungsweise Deckelteil (4) angeordnet sind, **dadurch gekennzeichnet, dass** das untere Gelenkteil (6) als Verschiebebolzen (8) mit einem an einem Flanschende (9) zumindest teilweise umlaufenden Randflansch (10) ausgebildet ist, wobei an einem dem Flanschende (9) gegenüberliegenden Lagerende (11) das obere Gelenkteil (7) verschwenkbar gelagert ist, welcher Randflansch (10) einen ovalen, eckigen oder anderen nicht-kreisförmigen Querschnitt aufweist, welcher im Wesentlichen einem Querschnitt einer Randflanschvertiefung (13) im Kastenunterteil (2) entspricht.

2. Kasten nach Anspruch 1, wobei der Verschiebebolzen (8) einen im Wesentlichen kreisförmigen Querschnitt und eine glatte Außenseite (12) aufweist.

3. Kasten nach Anspruche 1 oder 2, wobei die Randflanschvertiefung (13) an einem Ende (14) einer Verschlebebolzenbohrung (15) in einem Randbereich (16) des Kastenunterteils (2) ausgebildet ist.

4. Kasten nach einem der vorangehenden Ansprüche, wobei ein Schwenkbereich (17) von oberem Gelenkteil (7) zum unteren Gelenkteil (6) größer als 90°, vorzugsweise in etwa 180° und insbesondere bevorzugt bis zu 220° ist.

5. Kasten nach einem der vorangehenden Ansprüche, wobei das obere Gelenkteil (7) einen Einschraubbolzen (18) zumindest an seinem zu dem mit dem unteren Gelenkteil (6) verschwenkbar verbundenen Schwenkendabschnitt (19) gegenüberliegenden Einschraubabschnitt (20) aufweist.

6. Kasten nach einem der vorangehenden Ansprüche, wobei das Lagerende (11) zwei voneinander durch einen Lagerspalt (21) beabstandete Lagervorsprünge (22) aufweist, zwischen denen eine Lagerwelle (23) für das Verschwenken des oberen Gelenkteils (7) angeordnet Ist.

7. Kasten nach einem der vorangehenden Ansprüche, wobei ein Durchmesser (24) des oberen Gelenkteils (7) kleiner oder höchsten gleich einem Durchmesser (25) des unteren Gelenkteils (6) ist.

8. Kasten nach einem der vorangehenden Ansprüche, wobei das obere Gelenkteil (7) einen mittleren im Wesentlichen zentrischen Mittelabschnitt (26) aufweist, von dem der Einschraubendabschnitt (20) als mit Außengewinde (29) ausgebildeter Einschraubbolzen (18) und der Schwenkabschnitt (19) abstehen,

9. Kasten nach einem der vorangehenden Ansprüche, wobei das obere Gelenkteil (7) im Wesentlichen als Einschraubbolzen (18) mit Schwenkendabschnitt (19) ausgebildet ist.

10. Kasten nach einem der vorangehenden Ansprüche, wobei zwischen Mittelabschnitt (26) und Einschraubbolzen (18) ein Einschraubanschlag (27) ausgebildet ist.

11. Kasten nach einem der vorangehenden Ansprüche, wobei die Gelenkeinrichtung (3) im Wesentlichen an zwei Kastenecken (28) angeordnet ist.

## Claims

1. Box (1), in particular for use in areas subject to explosion hazards (2), with a lower box part and a cover part (4) mounted pivotably relative to this lower box part by means of a hinge device (3), wherein the hinge device (3) has a lower hinge part (6) associated with the lower box part and an upper hinge part (7) associated with the cover part, which are pivotably connected to each other, wherein are arranged one hinge part (6, 7) mounted slidably and the other hinge part (7, 6) at least partially screwable in the respectively associated lower box part (2) or cover part (4), **characterized in that** the lower hinge part (6) is formed as a displacement bolt (8) with an at least partially circumferential edge flange (10), wherein the upper hinge part (7) is pivotably mounted on a bearing end (11) opposite the flange end (9), which edge flange (10) has an oval, cornered or other non-circular cross-section, which substantially corresponds to a cross-section of an edge flange depression (13) in the lower box part (2).

2. Box according to Claim 1, wherein the displacement bolt (8) has a substantially circular cross-section and a smooth outside (12).

3. Box according to Claims 1 or 2, wherein the edge flange depression (13) is formed at one end (14) of a displacement bolt hole (15) in an edge region (16) of the lower box part (2).

4. Box according to any one of the preceding claims, wherein a pivot range (17) of the upper hinge part (7) with respect to the lower hinge part (6) is greater than 90°, preferably approximately 180°, and particularly preferably up to 220°.

5. Box according to any one of the preceding claims, wherein the upper hinge part (7) has a screw-in bolt (18) at least on its screw-in section (20) opposite the pivot end section (19) which is pivotably connected to the lower hinge part (6).

6. Box according to any one of the preceding claims, wherein the bearing end (11) has two bearing projections (22) which are separated from each other by a bearing gap (21) and between which a bearing shaft (23) for pivoting the upper hinge part (7) is arranged.

7. Box according to any one of the preceding claims, wherein a diameter (24) of the upper hinge part (7) is smaller than or at most equal to a diameter (25) of the lower hinge part (6).

8. Box according to any one of the preceding claims, wherein the upper hinge part (7) has a middle, substantially centered middle section (26) from which the screw-in end section (20), as a screw-in bolt (18) formed with a male thread (29), and the pivot section (19) protrude.

9. Box according to any one of the preceding claims, wherein the upper hinge part (7) substantially takes the form of a screw-in bolt (18) with a pivot end section (19).

10. Box according to any one of the preceding sections, wherein a screwing-in stop (27) is formed between the middle section (26) and the screw-in bolt (18).

11. Box according to any one of the preceding claims, wherein the hinge device (3) is arranged substantially at two box corners (28).

## Revendications

1. Boîte (1), notamment destinée à être utilisée en milieu explosif, munie d'une partie inférieure de boîte (2) et d'un couvercle (4) qui est monté de façon à pouvoir pivoter entre une position ouverte et une position fermée par rapport à la partie inférieure au moyen d'une articulation (3), dans laquelle l'articulation (3) comporte une partie d'articulation inférieure qui est associée à la partie inférieure de boîte (2) et une partie d'articulation supérieure (6, 7) qui est associée au couvercle, qui sont reliées entre elles de façon pivotante, une partie d'articulation (6, 7) étant montée de façon coulissante et l'autre partie d'articulation (7, 6) étant disposée dans la partie inférieure de boîte (2) associée respectivement le couvercle (4) associé de façon à pouvoir être vissée au moins partiellement, **caractérisée en ce que** la partie d'articulation inférieure (6) est conçue comme un boulon coulissant (8) muni d'une bride (10) entourant au moins partiellement une extrémité de bride (9), dans laquelle la partie d'articulation supérieure (7) est montée de façon pivotante à une extrémité de palier (11) opposée à l'extrémité de bride (9), laquelle bride (10) présente une section transversale ovale, rectangulaire ou autre non circulaire, qui correspond essentiellement à une section transversale d'un évidement de bride (13) dans la partie inférieure de boîte (2).

2. Boîte selon la revendication 1, dans laquelle le boulon coulissant (8) présente une section transversale essentiellement circulaire et une face extérieure lisse (12).

3. Boîte selon la revendication 1 ou 2, dans laquelle l'évidement de bride (13) est formé à une extrémité (14) d'un alésage de boulon coulissant (15) dans une région périphérique (16) de la partie inférieure de boîte (2).

4. Boîte selon l'une quelconque des revendications précédentes, dans laquelle une plage de pivotement (17) de la partie d'articulation supérieure (7) à la partie d'articulation inférieure (6), est supérieure à 90° de préférence d'environ 180° et de manière particulièrement préférée jusqu'à 220°.

5. Boîte selon l'une quelconque des revendications précédentes, dans laquelle la partie d'articulation supérieure (7) présente un boulon à visser (18) au moins dans sa partie de vissage (20) opposée à la partie d'extrémité pivotante (19) reliée de façon pivotante à la partie d'articulation inférieure (6).

6. Boîte selon l'une quelconque des revendications précédentes, dans laquelle l'extrémité de palier (11) présente deux saillies de palier (22) espacées l'une de l'autre par un interstice de palier (21), entre lesquelles est disposé un arbre de palier (23) pour faire pivoter la partie d'articulation supérieure (7).

7. Boîte selon l'une quelconque des revendications précédentes, dans laquelle un diamètre (24) de la partie d'articulation supérieure (7) est inférieur ou au plus égal à un diamètre (25) de la partie d'articulation inférieure (6).

8. Boîte selon l'une quelconque des revendications précédentes, dans laquelle la partie d'articulation supérieure (7) présente une partie intermédiaire médiane (26), essentiellement centrale, à partir de laquelle la partie de vissage (20) en tant que boulon à visser (18) formé avec un filetage extérieur (29) et la partie d'extrémité pivotante (19) font saillie.

9. Boîte selon l'une quelconque des revendications précédentes, dans laquelle la partie d'articulation supérieure (7) est conçue essentiellement comme un boulon à visser (18) avec la partie d'extrémité pivotante (19).

10. Boîte selon l'une quelconque des revendications précédentes, dans laquelle une butée à visser (27) est formée entre la partie intermédiaire médiane (26) et le boulon à visser (18).

11. Boîte selon l'une quelconque des revendications précédentes, dans laquelle l'articulation (3) est disposée essentiellement sur deux angles de boîte (28).
